(19) Europäisches Patentamt
European Patent Office
Office européen des brevets

(11) **EP 3 889 623 B1**

(12) **FASCICULE DE BREVET EUROPEEN**

(45) Date de publication et mention
de la délivrance du brevet:
**12.02.2025 Bulletin 2025/07**

(21) Numéro de dépôt: **21165485.0**

(22) Date de dépôt: **29.03.2021**

(51) Classification Internationale des Brevets (IPC):
*G01R 31/26* (2020.01)   *G01R 27/26* (2006.01)

(52) Classification Coopérative des Brevets (CPC):
**G01R 31/2621; G01R 27/2605; G01R 31/2648**

(54) **CARACTÉRISATION DE TRANSISTORS**

CHARAKTERISIERUNG VON TRANSISTOREN

CHARACTERISATION OF TRANSISTORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.03.2020 FR 2003211**

(43) Date de publication de la demande:
**06.10.2021 Bulletin 2021/40**

(73) Titulaire: **Commissariat à l'Energie Atomique et aux Energies Alternatives
75015 Paris (FR)**

(72) Inventeurs:
• **VIEY, Abygael**
**38054 GRENOBLE CEDEX 09 (FR)**
• **VANDENDAELE, William**
**38054 GRENOBLE CEDEX 09 (FR)**
• **CLUZEL, Jacques**
**38054 GRENOBLE CEDEX 09 (FR)**
• **COIGNUS, Jean**
**38054 GRENOBLE CEDEX 09 (FR)**

(74) Mandataire: **Cabinet Beaumont
4, Place Robert Schuman
B.P. 1529
38025 Grenoble Cedex 1 (FR)**

(56) Documents cités:
**GB-A- 2 351 156**

• **MIN-KYU JOO ET AL: "Flat-band voltage and low-field mobility analysis of junctionless transistors under low-temperature", SEMICONDUCTOR SCIENCE AND TECHNOLOGY, IOP PUBLISHING LTD, GB, vol. 29, no. 4, 5 March 2014 (2014-03-05), pages 45024, XP020259895, ISSN: 0268-1242, [retrieved on 20140305], DOI: 10.1088/0268-1242/29/4/045024**

EP 3 889 623 B1

**Description**

Domaine technique

La présente description concerne de façon générale les dispositifs électroniques et, plus particulièrement, les procédés de caractérisation de transistors à effet de champ.

Technique antérieure

Pour caractériser un transistor à effet de champ, on peut notamment évaluer la mobilité effective des porteurs de charge majoritaires (électrons ou trous) dans son canal de conduction. Les valeurs de mobilité effective obtenues par les procédés de caractérisation usuels sont toutefois souvent erronées, par exemple du fait d'un piégeage de charges pendant la mesure. Cela fausse la caractérisation du transistor.

Le document GB 2351156 décrit une modélisation de caractéristiques électriques de transistors à couches minces. Pour ce faire, ce document propose un procédé de caractérisation d'un transistor à effet de champ, comportant la mesure d'un courant de drain vs. une tension de grille, ainsi que la mesure d'une capacité vs. la tension de grille.

Résumé de l'invention

Il existe un besoin d'améliorer les dispositifs et procédés de caractérisation de transistors.

Un mode de réalisation pallie tout ou partie des inconvénients des dispositifs et procédés de caractérisation de transistors connus.

L'invention, comme définie par la revendication 1, prévoit un procédé de caractérisation d'un transistor à effet de champ, comportant :

    une étape d'application, sur la grille du transistor, par un premier appareil de mesure de caractéristiques courant-tension par impulsion configuré pour soumettre la grille à des impulsions de tension et pour mesurer un courant électrique qui en résulte, d'une seule rampe de tension de grille ;
    une étape de mesure d'un courant de drain et d'une capacité de grille du transistor pendant l'application de la rampe de tension de grille ; et
    une étape d'interprétation à la fois de variations de la capacité de grille et de variations du courant de drain du transistor.

Selon un mode de réalisation, la rampe est appliquée pendant une durée comprise entre 1 $\mu$s et 20 $\mu$s, de préférence entre 1 $\mu$s et 5 $\mu$s.

Selon un mode de réalisation, la rampe est une droite de pente sensiblement constante.

Selon un mode de réalisation, la pente de la rampe est comprise, en valeur absolue, entre 0,1 V/$\mu$s et 10 V/$\mu$s, de préférence entre 0,5 V/$\mu$s et 1,5 V/$\mu$s.

Selon un mode de réalisation, le drain du transistor est soumis, pendant l'application de la rampe, à une tension de drain comprise entre 1 mV et 500 mV, de préférence entre 50 mV et 150 mV, par rapport à la source du transistor.

Selon un mode de réalisation, la source et un substrat du transistor sont, pendant l'application de la rampe, portés à un potentiel de référence, de préférence la masse.

Selon un mode de réalisation, les variations de capacité de grille du transistor sont déduites de variations du courant de déplacement dans le transistor pendant l'application de la rampe.

Selon un mode de réalisation, une valeur de mobilité effective des porteurs dans le transistor est calculée à partir :

    de la longueur de grille du transistor ;
    de la largeur de grille du transistor ;
    du courant de drain du transistor ;
    de la tension de drain du transistor ; et
    de l'intégrale de la capacité de grille du transistor par rapport à la tension de grille pendant l'application de la rampe.

Selon un mode de réalisation, un courant de fuite de grille du transistor est déduit d'une mesure du courant de source et d'une mesure de courant de drain pendant l'application de la rampe.

Selon un mode de réalisation, un décalage de tension de seuil du transistor est évalué pendant des premières phases successives d'application de la rampe de tension de grille, entrecoupées par des deuxièmes phases d'application d'une tension constante non nulle sur la grille du transistor.

L'invention, comme définie par la revendication 11, prévoit un dispositif électronique adapté à mettre en œuvre le procédé tel que décrit, le dispositif comprenant :

    un premier appareil de mesure de caractéristiques courant-tension par impulsions pouvant être relié, de préférence connecté, à la grille du transistor ;
    un système d'acquisition de mesures relié au premier appareil de mesure de caractéristiques courant-tension par impulsions ; et
    un deuxième appareil de mesure de caractéristiques courant-tension par impulsions pouvant être relié, de préférence connecté, au drain du transistor,
    dans lequel le premier appareil est configuré pour appliquer:

-    des impulsions de tension d'amplitude croissante, dans un cas où la rampe présente une pente positive; et
-    des impulsions de tension d'amplitude décroissante dans un cas où la rampe présente une pente négative.

Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :

la figure 1 est une vue en coupe, schématique et partielle, d'un exemple de transistor du type auquel s'appliquent, à titre d'exemple, les modes de réalisation et modes de mise en œuvre décrits ;

la figure 2 est un schéma électrique d'un exemple de dispositif électronique de caractérisation de transistors ;

la figure 3 est un exemple de chronogramme associé à un exemple de procédé de caractérisation de transistors ;

la figure 4 est une vue en coupe, schématique et partielle, du transistor de la figure 1 au cours d'une étape du procédé de la figure 3 ;

la figure 5 est une vue en coupe, schématique et partielle, du transistor de la figure 1 au cours d'une autre étape du procédé de la figure 3 ;

la figure 6 est un exemple de graphique de variation de courant de source et de courant de drain du transistor de la figure 1 lors de la mise en œuvre du procédé de la figure 3 ;

la figure 7 est un schéma électrique d'un mode de réalisation d'un dispositif électronique de caractérisation de transistors ;

la figure 8 est un exemple de chronogramme associé à un mode de mise en œuvre d'un procédé de caractérisation de transistors ;

la figure 9 est un schéma électrique d'un mode de réalisation d'un autre dispositif électronique de caractérisation de transistors ;

la figure 10 est une vue en coupe simplifiée, schématique et partielle, d'un exemple de transistor dans un mode de fonctionnement ;

la figure 11 est une vue en coupe simplifiée, schématique et partielle, du transistor de la figure 10 dans un autre mode de fonctionnement ; et

la figure 12 est un exemple de chronogramme associé à un mode de mise en œuvre d'un procédé d'évaluation d'une dérive de tension de seuil d'un transistor.

Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

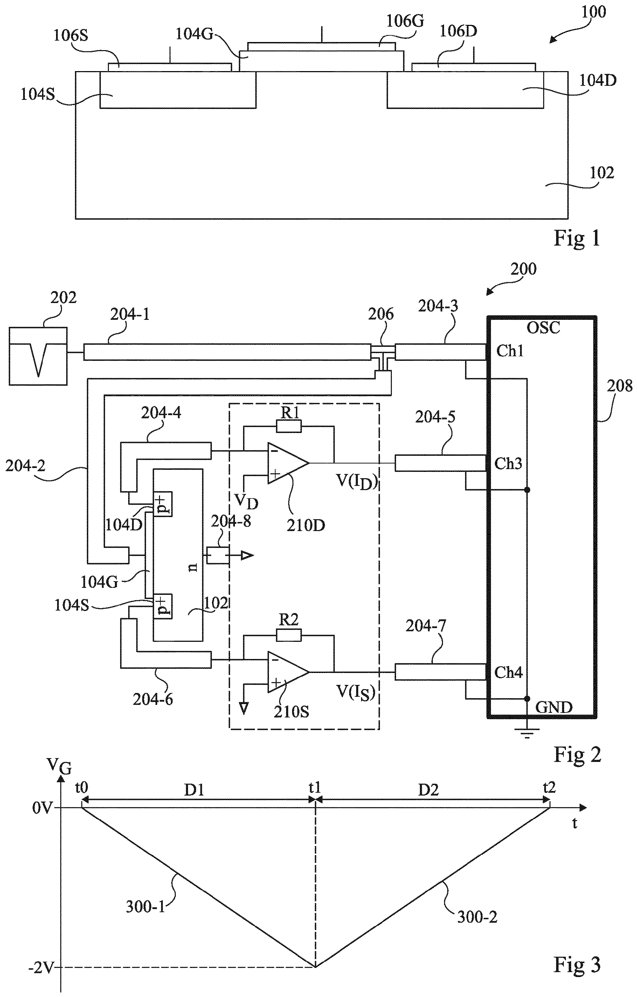

La figure 1 est une vue en coupe, schématique et partielle, d'un exemple de transistor 100 du type auquel s'appliquent, à titre d'exemple, les modes de réalisation et modes de mise en œuvre décrits.

Dans l'exemple représenté, le transistor 100 est un transistor à effet de champ. Le transistor 100 est, par exemple, un transistor à effet de champ de type métal-oxyde-semiconducteur, plus communément appelé transistor MOS (de l'anglais Metal-Oxide-Semiconductor). Le transistor 100 est par exemple réalisé dans et sur un substrat semiconducteur 102, par exemple une plaquette ou un morceau de plaquette en silicium dopé d'un premier type de conductivité.

Comme illustré en figure 1, le transistor 100 comporte une région de source 104S et une région de drain 104D. Dans l'exemple représenté, les régions de source 104S et de drain 104D sont disjointes, et s'étendent verticalement depuis la surface supérieure du substrat 102. Les régions de source 104S et de drain 104D sont par exemple chacune en silicium dopé d'un deuxième type de conductivité, différent du premier type de conductivité.

Le transistor 100 comporte en outre une région de grille 104G. Dans l'exemple représenté, la région de grille 104G est située sur et en contact avec la surface supérieure du substrat 102. En surface du substrat 102, la région de grille 104G s'étend horizontalement au-dessus d'une portion de substrat 102 bordée latéralement par les régions de source 104S et de drain 104D. En figure 1, la région de grille 104G se prolonge au-dessus des régions de source 104S et de drain 104D. Dans l'exemple représenté, la région de grille 104G revêt partiellement les surfaces supérieures respectives de la région de source 104S et de la région de drain 104D. La région 104G est typiquement en un matériau électriquement isolant, par exemple un oxyde.

Dans l'exemple représenté, une électrode de source 106S, une électrode de grille 106G et une électrode de drain 106D sont respectivement formées sur et en contact avec la région de source 104S, la région de grille 104G et la région de drain 104D du transistor 100. Chacune de ces électrodes 106S, 106G, 106D recouvre par exemple en partie la surface supérieure libre de la région 104S, 104G, 104D à laquelle elle est associée. À titre d'exemple, les électrodes 106S, 106G et 106D constituent respectivement des bornes de source, de grille et de drain du transistor 100. Les électrodes de source 106S, de grille 106G et de drain 106D sont, par exemple, en un matériau électriquement conducteur.

Dans un cas où le substrat 102 est dopé de type p et où les régions de source 104S et de drain 104D sont chacune dopées de type n, le transistor 100 est qualifié de transistor à canal n, ou transistor nMOS. Les porteurs de charge majoritaires sont dans ce cas des électrons. Si l'on applique, entre les électrodes de grille 106G et de source 106S du transistor 100, une tension $V_{GS}$ supérieure à une tension $V_{TH}$ de seuil, des électrons peuvent circuler au sein du canal n formé entre les régions de source 104S et de drain 104D.

Dans un autre cas où le substrat 102 est dopé de type n et où les régions de source 104S et de drain 104D sont chacune dopées de type p, le transistor 100 est qualifié de transistor à canal p, ou transistor pMOS. Les porteurs de charge majoritaires sont dans ce cas des trous. Si l'on applique, entre les électrodes de grille 106G et de source 106S du transistor 100, une tension $V_{GS}$ inférieure à la tension $V_{TH}$ de seuil, des trous peuvent circuler au sein du canal p formé entre les régions de source 104S et de drain 104D.

Lorsque l'on souhaite caractériser un transistor, par exemple le transistor 100, on peut en particulier évaluer la mobilité effective, notée $\mu_{eff}$, des porteurs de charge majoritaires de son canal de conduction. Dit autrement, on peut évaluer la mobilité effective des électrons, dans le cas d'un transistor 100 du type nMOS, ou des trous, dans le cas d'un transistor 100 du type pMOS. La mobilité effective $\mu_{eff}$ est par exemple représentative des performances électriques et de la fiabilité du transistor 100.

Afin d'évaluer la mobilité effective $\mu_{eff}$ des porteurs d'un transistor tel que le transistor 100, on peut par exemple effectuer, en fonction d'un potentiel $V_G$ variable imposé sur sa grille, des mesures de courant $I_D$ de drain et des mesures de capacité C de grille. Ces deux catégories de mesures sont respectivement désignées par les termes « caractéristiques $I_D$ ($V_G$) » et « caractéristiques $C(V_G)$ » dans la suite de la description.

La figure 2 est un schéma électrique d'un exemple de dispositif électronique 200 de caractérisation de transistors. Le dispositif 200 peut en particulier permettre d'obtenir les caractéristiques $I_D(V_G)$ et $C(V_G)$ d'un transistor, par exemple le transistor 100 de la figure 1. Dans l'exemple de la figure 2, on considère que le transistor 100 est un transistor du type pMOS dont le substrat 102 est dopé de type n et dont les régions de source 104S et de drain 104D sont chacune fortement dopées de type p (p+).

Dans l'exemple représenté, le dispositif 200 comporte un générateur 202 de signaux, par exemple un générateur d'impulsions. Une sortie du générateur 202 de signaux est reliée ou connectée à la grille du transistor 100, c'est-à-dire à l'électrode de grille 106G (non représentée), par l'intermédiaire de deux câbles 204-1 et 204-2 entre lesquels est intercalé un té 206 de raccordement.

La sortie du générateur 202 est en outre reliée ou connectée à une entrée (Ch1) d'un dispositif électronique 208 (OSC) d'acquisition et/ou d'enregistrement, par exemple un oscilloscope, par l'intermédiaire du câble 204-1, du té 206 et d'un autre câble 204-3. Plus précisément, en figure 2, une extrémité du câble 204-3 est connectée au té 206, l'autre extrémité du câble 204-3 étant connectée à l'entrée Ch1 de l'oscilloscope 208.

Dans l'exemple représenté, le drain du transistor 100, c'est-à-dire l'électrode de drain 106D (non représentée), est connecté à une entrée inverseuse (-) d'un amplificateur 210D opérationnel par l'intermédiaire d'un autre câble 204-4. L'entrée non inverseuse (+) de l'amplificateur 210D est portée à un potentiel de drain noté $V_D$. En sortie de l'amplificateur 210D, on obtient une tension $V(I_D)$ image du courant $I_D$ de drain du transistor 100, par exemple proportionnelle au courant $I_D$. Dans l'exemple représenté, la sortie de l'amplificateur 210D est connectée à une autre entrée (Ch3) de l'oscilloscope 208 par l'intermédiaire d'un autre câble 204-5. En figure 2, une résistance (R1) est connectée entre l'entrée inverseuse et la sortie de l'amplificateur 210D.

Dans l'exemple représenté, la source du transistor 100, c'est-à-dire l'électrode de source 106S (non représentée en figure 2), est connectée à une entrée inverseuse (-) d'un autre amplificateur 210S opérationnel par l'intermédiaire d'un autre câble 204-6. L'entrée non inverseuse (+) de l'amplificateur 210S est portée à un potentiel de référence, par exemple la masse. En sortie de l'amplificateur 210S, on obtient une tension $V(I_s)$ image d'un courant $I_s$ de source du transistor 100, par exemple proportionnelle au courant $I_s$. Dans l'exemple représenté, la sortie de l'amplificateur 210S est connectée à une autre entrée (Ch4) de l'oscilloscope 208 par l'intermédiaire d'un autre câble 204-7. En figure 2, une autre résistance (R2) est connectée entre l'entrée inverseuse et la sortie de l'amplificateur 210S.

En figure 2, le substrat 102 du transistor 100 est porté au potentiel de référence. Dans l'exemple représenté, la face du substrat 102 opposée aux régions de source 104S, de grille 104G et de drain 104D est mise à la masse par l'intermédiaire d'un autre câble 204-8.

Les câbles 204-1, 204-2, 204-3, 204-4, 204-5, 204-6, 204-7 et 204-8 sont par exemple des câbles coaxiaux, dont la gaine est mise à la masse. Dans l'exemple représenté, la gaine de chaque câble 204-3, 204-5, 204-7 est connectée à une borne de masse (GND) de l'oscilloscope 208. À titre d'exemple, le générateur 202 de signaux et l'oscilloscope 208 du circuit 200 peuvent respectivement avoir une impédance de sortie et une impédance d'entrée égales à environ 50 Ω.

Le fonctionnement du dispositif 200 est exposé plus en détail en relation avec les figures 3 à 6 ci-dessous.

La figure 3 est un exemple de chronogramme associé à un exemple de procédé de caractérisation de transistors. La figure 3 illustre par exemple l'évolution, en fonction du temps (t), de la tension $V_G$ imposée sur l'électrode de grille 106G (figure 1) du transistor 100 par le générateur 202 (figure 2) du dispositif 200.

Dans l'exemple représenté, la tension $V_G$ de grille suit d'abord une première rampe 300-1 linéaire décroissante, autrement dit une droite de coefficient directeur négatif. La tension $V_G$ suit ensuite une deuxième rampe 300-2 linéaire croissante, autrement dit une autre droite de coefficient directeur positif. Dans l'exemple illustré en figure 3, la tension $V_G$ de grille décroît de 0 V à -2 V entre un instant t0 et un instant t1, postérieur à l'instant t0. La tension $V_G$ de grille croît ensuite de -2 V à 0 V entre l'instant t1 et un instant t2, postérieur à l'instant t1. En figure 3, les instants t0 et t1 sont séparés par une durée D1, tandis que les instants t1 et t2 sont séparés par une autre durée D2. À titre d'exemple, les durées D1 et D2 sont chacune de l'ordre de quelques microsecondes ou dizaines de microsecondes.

En pratique, la transition entre la rampe 300-1 de pente négative et la rampe 300-2 de pente positive peut s'effectuer par l'intermédiaire d'un plateau. La tension $V_G$ de grille peut par exemple être maintenue à une valeur constante d'environ -2 V pendant quelques dixièmes ou centièmes de microsecondes entre les rampes 300-1 et 300-2.

À titre d'exemple, lors des rampes 300-1 et 300-2, le potentiel $V_D$ (figure 2) de polarisation du drain du transistor 100 est maintenu à une valeur sensiblement constante. Le potentiel $V_D$ est par exemple maintenu égal à environ moins cent millivolts (-100 mV) entre les instants t0 et t2.

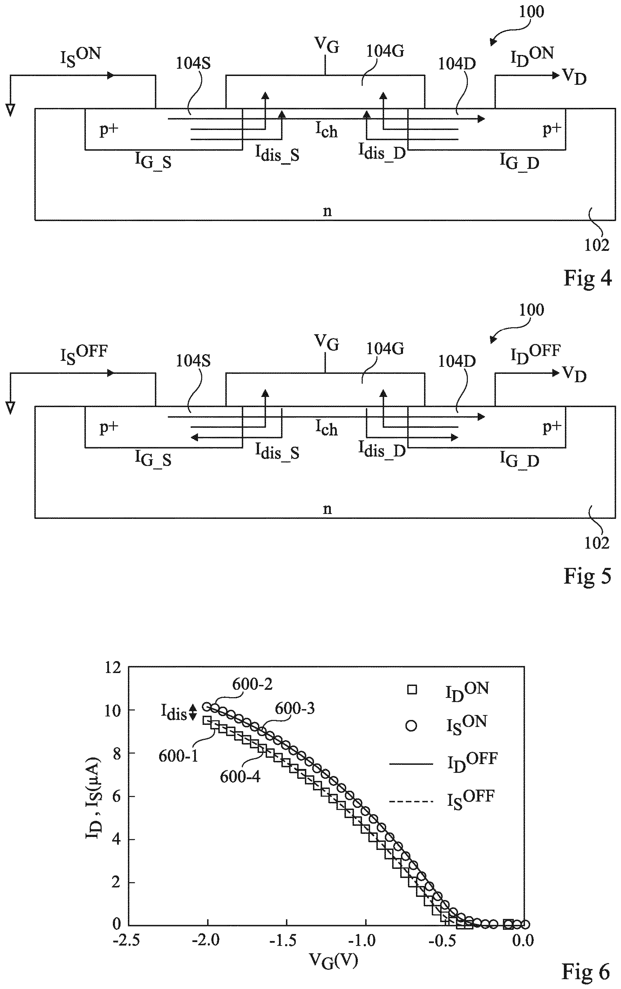

La figure 4 est une vue en coupe, schématique et partielle, du transistor 100 de la figure 1 au cours d'une étape du procédé de la figure 3. La figure 4 symbolise en particulier des courants électriques qui circulent dans le transistor 100 pendant l'application de la rampe 300-1 (figure 3) décroissante de tension $V_G$ de grille.

Dans la suite de la description, on note $I_D^{ON}$ et $I_S^{ON}$ les courants respectivement mesurés sur l'électrode 106D de drain et sur l'électrode 106S de source du transistor 100 (figure 1) au cours de la rampe 300-1 de pente négative.

Pendant l'application de la rampe 300-1, le courant $I_D^{ON}$ de drain est égal, en valeur absolue, à un courant de canal, noté $I_{ch}$, moins un courant de fuite de grille côté drain, noté $I_{G\_D}$, et moins un courant de déplacement côté drain, noté $I_{dis\_D}$. En d'autres termes, le courant $I_D^{ON}$ vérifie la relation suivante :

$$[\text{Math 1}]$$

$$| I_D^{ON} | = I_{ch} - I_{G\_D} - I_{dis\_D}$$

De façon analogue, pendant l'application de la rampe 300-1, le courant $I_S^{ON}$ de source est égal, en valeur absolue, à la somme d'un courant de fuite de grille côté source, noté $I_{G\_S}$, d'un courant de déplacement côté source, noté $I_{dis\_S}$, et du courant $I_{ch}$ de canal. En d'autres termes, le courant $I_S^{ON}$ vérifie la relation suivante :

$$[\text{Math 2}]$$

$$\left|I_S^{ON}\right| = I_{G\_S} + I_{dis\_S} + I_{ch}$$

Pendant la rampe 300-1, le courant $I_{dis\_D}$ de déplacement côté drain est dû à une charge d'une capacité comprise entre l'électrode de grille 106G et l'électrode de drain 106D du transistor 100 (figure 1). De façon analogue, pendant la rampe 300-1, le courant $I_{dis\_S}$ de déplacement côté source est dû à une charge d'une capacité comprise entre l'électrode de grille 106G et l'électrode de source 106S du transistor 100 (figure 1). Au cours de la rampe 300-1, le courant $I_{dis\_D}$ est orienté depuis la région 104D de drain vers la région 104G de grille, et le courant $I_{dis\_S}$ est orienté depuis la région 104S de source vers la région 104G de grille.

Le courant $I_{G\_D}$ de fuite de grille côté drain correspond à un courant indésirable traversant la région 104G de grille du côté de la région 104D de drain. De façon analogue, le courant $I_{G\_S}$ de fuite de grille côté source correspond à un courant indésirable traversant la région 104G de grille du côté de la région 104S de source. Au cours de la rampe 300-1, le courant $I_{G\_D}$ est orienté depuis la région 104D de drain vers la région 104G de grille, et le courant $I_{G\_S}$ est orienté depuis la région 104S de source vers la région 104G de grille.

Au cours de la rampe 300-1, le courant $I_{ch}$ de canal est orienté depuis la région de source 104S vers la région de drain 104D.

La figure 5 est une vue en coupe, schématique et partielle, du transistor 100 de la figure 1 au cours d'une autre étape du procédé de la figure 3. La figure 5 symbolise en particulier des courants électriques qui circulent dans le transistor 100 pendant l'application de la rampe 300-2 (figure 3) croissante de tension $V_G$ de grille.

Dans la suite de la description, on note $I_D^{OFF}$ et $I_S^{OFF}$ les courants respectivement mesurés sur l'électrode de drain 106D et sur l'électrode de source 106S du transistor 100 (figure 1) au cours de la rampe 300-2 de pente positive.

Pendant l'application de la rampe 300-2, le courant $I_D^{OFF}$ de drain est égal, en valeur absolue, à la somme du courant $I_{dis\_D}$ de déplacement côté drain et du courant $I_{ch}$ de canal, moins le courant $I_{G\_D}$ de fuite de grille côté drain. En d'autres termes, le courant $I_D^{OFF}$ vérifie la relation suivante :

[Math 3]

$$|I_D^{OFF}| = I_{dis\_D} + I_{ch} - I_{G\_D}$$

De façon analogue, pendant l'application de la rampe 300-2, le courant $I_S^{OFF}$ de source est égal, en valeur absolue, à la somme du courant $I_{G\_S}$ de fuite de grille côté source et du courant $I_{ch}$ de canal, moins le courant $I_{dis\_S}$ de déplacement côté source. En d'autres termes, le courant $I_S^{OFF}$ vérifie la relation suivante :

[Math 4]

$$\left| I_S^{OFF} \right| = I_{G\_S} - I_{dis\_S} + I_{ch}$$

Pendant la rampe 300-2, le courant $I_{dis\_D}$ de déplacement côté drain est dû à une décharge de la capacité comprise entre l'électrode de grille 106G et l'électrode de drain 106D du transistor 100 (figure 1). De façon analogue, pendant la rampe 300-2, le courant $I_{dis\_S}$ de déplacement côté source est dû à une décharge de la capacité comprise entre l'électrode de grille 106G et l'électrode de source 106S du transistor 100 (figure 1). Au cours de la rampe 300-2, le courant $I_{dis\_D}$ est orienté depuis la région 104G de grille vers la région 104D de drain, et le courant $I_{dis\_S}$ est orienté depuis la région 104G de grille vers la région 104S de source.

Pendant la rampe 300-2, le courant $I_{G\_D}$ de fuite côté drain, le courant $I_{G\_S}$ de fuite côté source et le courant $I_{ch}$ de canal sont orientés de la même façon que pendant la rampe 300-1.

Dans l'exemple du procédé exposé ci-dessus en relation avec les figures 3 à 5, les courants $I_D^{ON}$ et $I_S^{ON}$ mesurés pendant la rampe 300-1 et les courants $I_D^{OFF}$ et $I_S^{OFF}$ mesurés pendant la rampe 300-2 permettent d'obtenir le courant $I_D$ de drain en appliquant la formule suivante :

[Math 5]

$$I_D = \frac{|I_D^{ON}| + |I_D^{OFF}| + |I_S^{ON}| + |I_S^{OFF}|}{4}$$

À partir de la formule précédente, on peut en déduire la caractéristique $I_D(V_G)$ du transistor 100.

En outre, dans l'exemple du procédé exposé ci-dessus en relation avec les figures 3 à 5, les courants $I_D^{ON}$ et $I_S^{ON}$ mesurés pendant la rampe 300-1 et les courants $I_D^{OFF}$ et $I_S^{OFF}$ mesurés pendant la rampe 300-2 permettent d'obtenir un courant de fuite de grille, noté $I_G$, en appliquant la formule suivante :

[Math 6]

$$I_G = \frac{\left|I_S^{ON}\right| + \left|I_S^{OFF}\right| - |I_D^{ON}| - |I_D^{OFF}|}{2}$$

À partir des équations [Math 1] à [Math 4] ci-dessus, on peut en déduire un courant de déplacement global, noté $I_{dis}$. Le courant $I_{dis}$ vérifie la relation suivante :

[Math 7]

$$I_{dis} = \frac{\left|I_S^{ON}\right| - \left|I_S^{OFF}\right| + |I_D^{OFF}| - |I_D^{ON}|}{2}$$

Partant du courant $I_{dis}$, on peut en déduire la caractéristique $C(V_G)$ du transistor 100 en appliquant la formule suivante :

[Math 8]

$$C = \frac{I_{dis}}{\dfrac{dV_G}{dt}}$$

En supposant que le transistor 100 présente une longueur L de grille et une largeur W de grille, on peut calculer la mobilité $\mu_{eff}$ effective du transistor 100 en appliquant la relation suivante :

[Math 9]

$$\mu_{eff} = \frac{L}{W} \cdot \frac{I_D}{Q_i V_D}$$

Dans la relation [Math 9], $Q_i$ représente la densité de charges mobiles dans le canal du transistor 100. La densité $Q_i$ correspond à l'intégrale de la caractéristique $C(V_G)$ :

[Math 10]

$$Q_i = \int_{+\infty}^{V_G} C \, dV_G$$

La figure 6 est un exemple de graphique de variation du courant $I_S$ de source (en microampères) et du courant $I_D$ de drain (en microampères) du transistor 100 de la figure 1 en fonction du potentiel $V_G$ de grille (en volts) lors de la mise en œuvre du procédé de la figure 3. En particulier, la figure 6 illustre un exemple d'évolution du courant $I_D^{ON}$ (courbe 600-1) et du courant $I_S^{ON}$ (courbe 600-2) pendant la rampe 300-1, ainsi que du courant $I_D^{OFF}$ (courbe 600-3) et du courant $I_S^{OFF}$ (courbe 600-4) pendant la rampe 300-2.

Dans l'exemple représenté, les courbes 600-1 et 600-4 sont quasiment superposées et les courbes 600-2 et 600-3 sont quasiment superposées. Comme illustré en figure 6, le courant $I_{dis}$ de déplacement est dans ce cas sensiblement égal, pour un potentiel $V_G$ de grille donné, par exemple -2 V, à l'écart entre les courbes 600-2 et 600-4 ou à l'écart entre les courbes 600-3 et 600-1. En d'autres termes, dans l'exemple représenté où $I_D^{ON} \approx I_S^{OFF}$ et où $I_D^{OFF} \approx I_S^{ON}$, la relation [Math 7] peut être simplifiée comme suit :

[Math 11]

$$I_{dis} \approx \left| I_S^{ON} \right| - \left| I_S^{OFF} \right| \approx \left| I_D^{OFF} \right| - \left| I_D^{ON} \right|$$

Un inconvénient du procédé de caractérisation exposé ci-dessus en relation avec les figures 3 à 6 tient au fait que, comme dans l'exemple illustré en figure 6, les courbes 600-1 et 600-4 sont souvent très proches des courbes 600-2 et 600-3. Cela ne permet généralement pas d'estimer avec précision la valeur du courant $I_{dis}$ de déplacement, et la caractéristique $C(V_G)$ du transistor s'en retrouve faussée.

Un autre inconvénient du procédé de caractérisation exposé ci-dessus en relation avec les figures 3 à 6 tient au fait que l'estimation du courant $I_{dis}$ de déplacement requiert l'application de deux rampes 300-1 et 300-2 de pentes opposées. Les mesures effectuées pendant la rampe 300-2 sont par exemple susceptibles d'être perturbées par des états pièges pouvant par exemple être activés lors de l'application de la rampe 300-1. Cela peut fausser l'estimation du courant $I_{dis}$ et nuire à la précision de la caractéristique $C(V_G)$ obtenue à l'issue des deux rampes 300-1 et 300-2.

Ce qui a été décrit ci-dessus en relation avec un exemple de transistor du type pMOS s'applique également à d'autres transistors à effet de champ, par exemple des transistors du type nMOS.

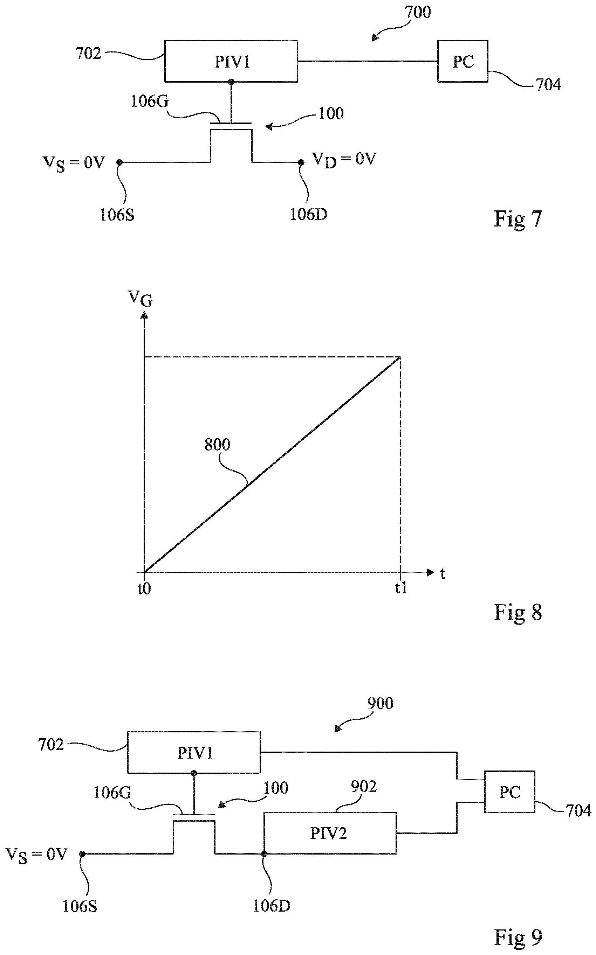

La figure 7 est un schéma électrique d'un mode de réalisation d'un dispositif électronique 700 de caractérisation de transistors, par exemple le transistor 100 de la figure 1. Dans la suite de la description, on considère que le transistor 100 est un transistor de type nMOS dont le substrat 102 est par exemple dopé de type p et dont les régions de source 104S et de drain 104D sont par exemple dopées chacune de type n.

Le dispositif 700 comporte un premier appareil 702 (PIV1) de mesure de caractéristiques courant-tension par impulsions (en anglais Pulsed IV). À titre d'exemple, l'appareil 702 est un appareil de mesure connu sous la dénomination commerciale « Model B1350 » de la société KEYSIGHT. L'appareil 702 est relié, de préférence connecté, à l'électrode ou borne 106G de grille du transistor 100. Dans l'exemple représenté, l'appareil 702 est en outre relié à un système 704 (PC) d'acquisition de mesures, par exemple un ordinateur.

En fonctionnement, l'appareil 702 est configuré pour soumettre l'électrode 106G à des impulsions de tension $V_G$ et pour mesurer le courant électrique qui en résulte. Ce courant correspond au courant de déplacement $I_{dis}$ global comme exposé précédemment en relation avec la figure 5. Les impulsions de tension appliquées sur la grille du transistor 100 par l'appareil 702 présentent par exemple chacune une durée de l'ordre de la dizaine voire de la centaine de nanosecondes.

Dans l'exemple représenté, l'électrode de source 106S du transistor 100 est portée à un potentiel de référence, de préférence la masse ($V_S$ = 0 V). De façon analogue, l'électrode de drain 106D du transistor 100 est portée au potentiel de référence, de préférence la masse ($V_D$ = 0 V). En d'autres termes, la source et le drain du transistor 100 sont tous deux mis à la masse.

Le dispositif 700 permet notamment d'obtenir la caractéristique $C(V_G)$ d'un transistor en appliquant, sur l'électrode de grille 106G, une seule rampe de tension $V_G$ de pente positive ou négative. En pratique, l'appareil 702 du dispositif 700 est par exemple configuré pour appliquer, sur l'électrode de grille 106G du transistor 100, des impulsions de tension $V_G$ d'amplitude croissante dans le cas d'une rampe de pente positive.

La figure 8 est un exemple de chronogramme associé à un mode de mise en œuvre d'un procédé de caractérisation de transistors. La figure 8 correspond, par exemple, à un chronogramme d'un mode de mise en œuvre d'un procédé de caractérisation du transistor 100 en utilisant le dispositif 700 de la figure 7.

Dans l'exemple représenté, la tension $V_G$ de grille appliquée sur l'électrode 106G de grille du transistor 100 (figure 7) suit une rampe 800 de pente positive entre un instant t0 et un instant t1, postérieur à l'instant t0. La rampe 800 est par exemple une droite de pente sensiblement constante. Au cours de la rampe 800, on mesure le courant de déplacement $I_{dis}$ sur l'électrode 106G de grille. Cela permet par exemple d'en déduire la caractéristique $C(V_G)$ du transistor 100 en appliquant la formule [Math 8].

La rampe 800 est appliquée pendant une durée (t1 - t0) comprise entre 1 µs et 20 µs, de préférence entre 1 µs et 5 µs, par exemple égale à environ 3 µs.

Dans l'exemple représenté, la rampe 800 présente une pente $dV_G/dt$ comprise entre 0,1 V/µs et 10 V/µs, de préférence entre 0,5 V/µs et 1,5 V/µs. La rampe 800 présente par exemple une pente $dV_G/dt$ égale à environ 1 V/µs. Plus la rampe 800 est rapide, plus le courant $I_{dis}$ de déplacement est élevé. Un avantage d'utiliser une rampe 800 comportant une pente de l'ordre du volt par microseconde tient au fait que cela permet par exemple d'accéder à une précision de mesure supérieure à celle que l'on obtiendrait grâce au procédé exposé en relation avec la figure 6.

L'étape de mesure du courant $I_{dis}$ sur la grille du transistor 100 peut en pratique être précédée par une étape de calibration. L'étape de calibration s'effectue, par exemple, dans une configuration où des pointes de mesure de l'appareil 702 (figure 7) ne sont pas mises en contact avec le transistor 100. Cela permet par exemple d'obtenir une valeur de courant de déplacement parasite provenant d'une capacité intrinsèque de l'appareil 702. Cette valeur peut ensuite être retranchée à la mesure de courant $I_{dis}$ de déplacement effectuée en plaçant les pointes de mesure de l'appareil 702 en contact avec le transistor 100 et en appliquant la rampe 800 de tension $V_G$ de grille.

On a décrit en relation avec la figure 8 un mode de mise en œuvre dans lequel le transistor est du type pMOS et où la rampe 800 est de pente positive. Cela n'est toutefois pas limitatif. La personne du métier est capable d'adapter le mode de mise en œuvre décrit à d'autres types de transistors à effet de champ, notamment à un transistor du type nMOS. En outre, la personne du métier est capable de transposer le mode de mise en œuvre décrit à un procédé de caractérisation dans lequel la rampe de tension $V_G$ est une droite de pente négative et de valeur égale, au signe près, à la valeur de la pente 800.

La figure 9 est un schéma électrique d'un mode de réalisation d'un autre dispositif électronique 900 de caractérisation de transistors, par exemple le transistor 100. Le dispositif 900 de la figure 9 comprend des éléments communs avec le dispositif 700 de la figure 7. Ces éléments communs ne seront pas décrits de nouveau ci-après.

Le dispositif 900 de la figure 9 se distingue du dispositif 700 de la figure 7 principalement en ce que, dans le cas du dispositif 900, l'électrode 106D de drain du transistor 100 est reliée, de préférence connectée, à un deuxième appareil 902 (PIV2) de mesure de caractéristiques courant-tension par impulsions. L'appareil 902 est par exemple analogue à l'appareil 702. Dans l'exemple représenté, l'appareil 902 est relié à l'ordinateur 704 (PC).

En fonctionnement, l'appareil 902 est configuré pour soumettre l'électrode 106D de drain du transistor 100 à une tension $V_D$ comprise entre 1 mV et 500 mV, de préférence entre 50 mV et 150 mV. L'appareil 902 est par exemple configuré pour appliquer une tension égale à environ 100 mV sur le drain du transistor 100. En fonctionnement, l'appareil 902 est en outre configuré pour mesurer le courant $I_D$ de drain sur l'électrode 106D de drain du transistor 100.

En appliquant sur l'électrode 106G une unique rampe 800 (figure 8) de tension $V_G$ et en imposant sur l'électrode 106S une tension $V_S$ sensiblement constante, on peut mesurer à la fois des variations de courant de déplacement $I_{dis}$ et de courant de drain $I_D$. En d'autres termes, on peut, à partir d'une unique rampe, interpréter à la fois des variations de capacité C de grille et de courant $I_D$ de drain du transistor 100. Cela permet par exemple d'obtenir en une seule rampe 800 la caractéristique $C(V_G)$ et la caractéristique $I_D(V_G)$ du transistor 100. À partir de la caractéristique $C(V_G)$, on peut en particulier déduire la mobilité $\mu_{eff}$ des porteurs dans le canal du transistor 100, par exemple en appliquant la relation [Math 9].

On pourrait penser que la mesure de la caractéristique $C(V_G)$ serait perturbée par l'application d'une tension $V_D$ de drain non nulle, par exemple du fait d'une modification de différence de potentiel entre les électrodes de source 106S et de drain 106D. En pratique, les inventeurs ont toutefois constaté que l'application d'une tension $V_D$ inférieure à 500 mV a une influence négligeable sur les caractéristiques $C(V_G)$ obtenues. C'est en particulier le cas pour des transistors dont la capacité C de grille est supérieure à environ 10 pF, par exemple pour des transistors dont la grille présente une épaisseur de l'ordre de 30 nm et une surface de l'ordre de 8 000 $\mu m^2$ et est soumise à une rampe de pente égale à environ 1 V/$\mu$s.

Dans le mode de mise en œuvre exposé en relation avec la figure 9, on considère pour simplifier que le courant $I_{G\_S}$ de fuite de grille côté source et que le courant $I_{G\_D}$ de fuite de grille côté drain du transistor 100 sont tous deux négligeables. Cela peut par exemple se justifier par le fait que la région de grille 104G du transistor 100 présente une épaisseur de l'ordre de quelques dizaines de nanomètres. À titre d'exemple, la région de grille 104G est constituée d'une couche d'alumine ($Al_2O_3$) présentant une épaisseur de 30 nm.

À titre de variante, par exemple dans des cas où les courants $I_{G\_S}$ et $I_{G\_D}$ ne sont pas négligeables, un troisième appareil (non représenté) de mesure de caractéristiques courant-tension par impulsions peut être relié, de préférence connecté, à l'électrode 106S de source du transistor 100. À titre d'exemple, le troisième appareil peut être configuré pour appliquer une tension $V_S$ de source nulle et pour mesurer le courant $I_S$ de source pendant la rampe 800 (figure 8) de tension $V_G$. En considérant pour simplifier que le courant de fuite du substrat 102 (figure 1) est négligeable, le courant $I_G$ de fuite de grille vérifie dans ce cas la relation suivante :

$$[\text{Math } 12]$$

$$I_G = |I_D| - |I_S|$$

Bien que l'on ait décrit ci-dessus en relation avec les figures 7 à 9 des modes de mise en œuvre de procédés de caractérisation de transistors appliqués à un cas où le transistor 100 est du type nMOS, la personne du métier est capable de transposer ce qui a été précédemment exposé à d'autres types de transistors à effet de champ, en particulier à un cas où le transistor 100 est du type pMOS.

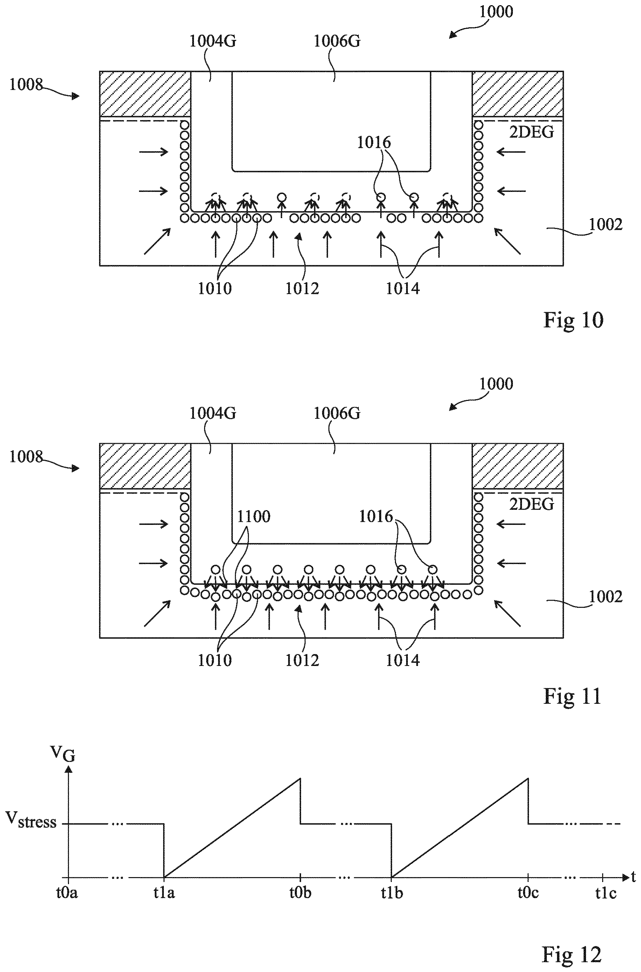

La figure 10 est une vue en coupe simplifiée, schématique et partielle, d'un exemple de transistor 1000 dans un mode de fonctionnement. La figure 10 symbolise plus particulièrement une accumulation de charges électriques au voisinage d'une interface entre un substrat 1002, dans et sur lequel est formé le transistor 1000, et une région 1004G d'oxyde de grille.

Dans l'exemple représenté, la région 1004G d'oxyde de grille présente, vue en coupe, une forme de « U ». La région 1004G s'étend verticalement depuis la surface supérieure du substrat 1002. Une électrode 1006G de grille est par exemple formée sur et en contact avec la région 1004G d'oxyde de grille.

En figure 10, la région 1004G sépare deux portions d'une couche 1008 de passivation revêtant partiellement la surface supérieure du substrat 1002. En figure 10, les portions de couche 1008 de passivation sont symbolisées par des zones hachurées.

À titre d'exemple :

le substrat 1002 est en nitrure de gallium (GaN) ;
la région 1004G d'oxyde de grille est en alumine $(Al_2O_3)$ ; et
la couche 1008 de passivation est en nitrure d'aluminium-gallium (AlGaN).

La figure 10 illustre en particulier une situation dans laquelle un potentiel de grille $V_G$ supérieur à une tension de seuil $V_{TH}$ du transistor 1000 est appliqué sur l'électrode 1006G de grille. Dans cette situation, des charges 1010 faisant partie d'un canal d'électrons 1012 formé entre deux parties d'un gaz d'électrons bidimensionnel (2DEG) sont soumises à un champ électrique symbolisé par des flèches 1014 dirigé vers l'électrode de grille 1006G. Cela entraîne le piégeage, dans la couche 1004G d'oxyde de grille, de charges 1016 issues du canal d'électrons 1012. Le mode de fonctionnement illustré en figure 10 est appelé « régime d'accumulation », du fait que des charges, dans ce cas, des électrons, sont accumulées dans la couche d'oxyde de grille 1004G.

La figure 11 est une vue en coupe simplifiée, schématique et partielle, du transistor 1000 de la figure 10 dans un autre mode de fonctionnement. La figure 11 symbolise plus particulièrement l'influence des charges électriques 1016 piégées dans la région 1004G d'oxyde de grille du transistor 1000.

La figure 11 illustre en particulier une situation postérieure à l'application, sur l'électrode de grille 1006G du transistor 1000, d'un potentiel de grille $V_G$ supérieur à la tension de seuil $V_{TH}$ pendant une durée par exemple de l'ordre de plusieurs secondes. Dans cette situation, les charges 1016 piégées dans la couche d'oxyde de grille 1004G produisent chacune un champ électrique symbolisé par des flèches 1100. Le champ électrique 1100 produit par chaque charge 1016 tend à s'opposer au champ électrique 1014 des charges 1010 du canal d'électrons 1012.

La présence des charges 1016 dans la couche 1004G est à l'origine d'un phénomène appelé instabilité de polarisation en température (Bias Temperature Instability - BTI). Ce phénomène entraîne notamment une dégradation progressive de performances électriques du transistor 1000. À titre d'exemple, ce phénomène peut être responsable d'un décalage ou d'une dérive $\Delta V_{TH}$ de la tension de seuil $V_{TH}$ du transistor 1000 en fonction du temps.

La figure 12 est un exemple de chronogramme associé à un mode de mise en œuvre d'un procédé d'évaluation d'une dérive $\Delta V_{TH}$ de tension de seuil d'un transistor, par exemple le transistor 1000 (figure 10).

Dans l'exemple représenté, on applique entre un instant t0 (t0a, t0b, t0c) et un instant t1 (t1a, t1b, t1c) une tension $V_G$ de grille sensiblement constante, notée $V_{stress}$, sur l'électrode 1006G (figure 10). Entre des instants t1 et t0 consécutifs, on cesse d'appliquer la tension $V_{stress}$ pour évaluer les caractéristiques $C(V_G)$ et $I_D(V_G)$ du transistor 1000. Pour cela, on applique des rampes de tension $V_G$ de grille par exemple analogues à la rampe 800 décrite en relation avec la figure 8. À titre d'exemple, la tension $V_{stress}$ est de l'ordre de plusieurs volts, par exemple égale à environ 4 V. La durée d'application de la tension $V_{stress}$ entre deux instants t0 et t1 consécutifs est, par exemple, de l'ordre de plusieurs secondes.

Les procédés d'évaluation des caractéristiques $C(V_G)$ et $I_D(V_G)$ exposés ci-dessus en relation avec les figures 7 à 9 permettent avantageusement de limiter la durée séparant chaque instant t1 de l'instant t0 suivant. Cela limite par exemple l'apparition d'un phénomène dit de recouvrement, durant lequel les charges 1016 (figure 10) piégées dans la couche 1004G d'oxyde de grille tendent à regagner le canal 1012 formé dans le substrat 1002. Le phénomène de recouvrement fausse en effet l'estimation de la caractéristique $C(V_G)$, car il est à l'origine d'une atténuation du champ électrique 1100.

Un avantage des procédés de caractérisation exposés ci-dessus en relation avec les figures 7 à 12 tient au fait qu'ils sont susceptibles de fournir une estimation du courant $I_{dis}$ de déplacement et une caractéristique $C(V_G)$ du transistor plus précises que celles que l'on obtiendrait par les procédés de caractérisation actuels.

Un autre avantage des procédés de caractérisation exposés ci-dessus en relation avec les figures 7 à 12 tient au fait que l'estimation du courant $I_{dis}$ de déplacement s'effectue par l'application d'une seule rampe 800. Les mesures effectuées pendant la rampe 800 sont notamment peu susceptibles d'être perturbées par des états pièges. Cela améliore la précision de l'estimation du courant $I_{dis}$ et de la caractéristique $C(V_G)$ obtenue à l'issue d'une unique rampe 800.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, ce qui est décrit ci-dessus en relation avec un mode de mise en œuvre dans lequel la rampe de tension 800 est de pente positive est transposable par la personne du métier à un cas où la rampe de tension appliquée sur la grille du transistor est de pente négative.

Enfin, la mise en œuvre pratique des modes de réalisation et variantes décrits est à la portée de la personne du métier à partir des indications fonctionnelles données ci-dessus. En particulier, la mise en œuvre pratique des appareils 702 et 902 de mesure de caractéristiques courant-tension par impulsions est à la portée de la personne du métier.

**Revendications**

1. Procédé de caractérisation d'un transistor (100 ; 1000) à effet de champ, comportant :

   une étape d'application, sur la grille (106G ; 1006G) du transistor, par un premier appareil (702) de mesure de caractéristiques courant-tension par impulsions configuré pour soumettre la grille à des impulsions de tension et pour mesurer un courant électrique ($I_{dis}$) qui en résulte, d'une seule rampe (800) de tension ($V_G$) de grille ;
   une étape de mesure d'un courant ($I_D$) de drain et d'une capacité (C) de grille du transistor (100 ; 1000) pendant l'application de la rampe (800) de tension ($V_G$) de grille ; et
   une étape d'interprétation à la fois de variations de la capacité (C) de grille et de variations du courant ($I_D$) de drain du transistor.

2. Procédé selon la revendication 1, dans lequel la rampe (800) est appliquée pendant une durée comprise entre 1 $\mu$s et 20 $\mu$s, de préférence entre 1 $\mu$s et 5 $\mu$s.

3. Procédé selon la revendication 1 ou 2, dans lequel la rampe (800) est une droite de pente sensiblement constante.

4. Procédé selon la revendication 3, dans lequel la pente de la rampe (800) est comprise, en valeur absolue, entre 0,1 V/$\mu$s et 10 V/$\mu$s, de préférence entre 0,5 V/$\mu$s et 1,5 V/$\mu$s.

5. Procédé selon l'une quelconque des revendications 1 à 4, dans lequel le drain (106D) du transistor (100 ; 1000) est soumis, pendant l'application de la rampe (800), à une tension ($V_D$) de drain comprise entre 1 mV et 500 mV, de préférence entre 50 mV et 150 mV, par rapport à la source (106S) du transistor.

6. Procédé selon l'une quelconque des revendications 1 à 5, dans lequel la source (1065) et un substrat (102 ; 1002) du transistor sont, pendant l'application de la rampe (800), portés à un potentiel de référence, de préférence la masse.

7. Procédé selon l'une quelconque des revendications 1 à 6, dans lequel les variations de capacité (C) de grille du transistor (100 ; 1000) sont déduites de variations du courant ($I_{dis}$) de déplacement dans le transistor pendant l'application de la rampe (800).

8. Procédé selon l'une quelconque des revendications 1 à 7, dans lequel une valeur de mobilité effective ($\mu_{eff}$) des porteurs dans le transistor (100 ; 1000) est calculée à partir :

   de la longueur (L) de grille du transistor ;
   de la largeur (W) de grille du transistor ;
   du courant ($I_D$) de drain du transistor ;
   d'une tension ($V_D$) de drain du transistor ; et
   de l'intégrale de la capacité (C) de grille du transistor par rapport à la tension ($V_G$) de grille pendant l'application de la rampe (800).

9. Procédé selon l'une quelconque des revendications 1 à 8, dans lequel un courant ($I_G$) de fuite de grille du transistor (100 ; 1000) est déduit d'une mesure du courant ($I_S$) de source et d'une mesure du courant ($I_D$) de drain pendant l'application de la rampe (800).

10. Procédé selon l'une quelconque des revendications 1 à 9, dans lequel un décalage ($\Delta V_{TH}$) de tension de seuil ($V_{TH}$) du transistor (100 ; 1000) est évalué pendant des premières phases successives d'application de la rampe (800) de tension ($V_G$) de grille, entrecoupées par des deuxièmes phases d'application d'une tension ($V_{stress}$) constante non nulle sur la grille (106G ; 1006G) du transistor.

11. Dispositif électronique adapté à mettre en œuvre le procédé selon l'une quelconque des revendications 1 à 10, le dispositif comprenant :

   le premier appareil (702) de mesure de caractéristiques courant-tension par impulsions pouvant être relié, de préférence connecté, à la grille (106G ; 1006G) du transistor (100 ; 1000) ;
   un système (704) d'acquisition de mesures relié au premier appareil (702) de mesure de caractéristiques courant-tension par impulsions ; et
   un deuxième appareil (902) de mesure de caractéristiques courant-tension par impulsions pouvant être relié, de préférence connecté, au drain (106D) du transistor,

   dans lequel le premier appareil applique :

   - des impulsions de tension d'amplitude croissante, dans un cas où la rampe (800) présente une pente positive ; et

- des impulsions de tension d'amplitude décroissante, dans un cas où la rampe présente une pente négative.

**Patentansprüche**

1. Verfahren zum Charakterisieren eines Feldeffekttransistors (100; 1000), das Folgendes aufweist:

    einen Schritt des Anlegens, an das Gate (106G; 1006G) des Transistors, durch ein erstes gepulstes Strom-vs.-Spannungs-Charakteristik-Messsystem (702), das konfiguriert ist zum Aussetzen des Gates gegenüber Spannungsimpulses und zum Messen eines resultierenden elektrischen Stroms ($I_{dis}$), einer einzelnen Rampe (800) der Gate-Spannung ($V_G$);
    einen Schritt des Messens eines Drainstroms ($I_D$) und einer Gate-Kapazität (C) des Transistors (100; 1000) während des Anlegens der Rampe (800) der Gate-Spannung ($V_G$); und
    einen Schritt der Interpretation sowohl von Änderungen der Gate-Kapazität (C) als auch von Änderungen des Drain-Stroms ($I_D$) des Transistors.

2. Verfahren nach Anspruch 1, wobei die Rampe (800) für eine Zeitdauer im Bereich von 1 $\mu$s bis 20 $\mu$s, bevorzugt von 1 $\mu$s bis 5 $\mu$s, angelegt wird.

3. Verfahren nach Anspruch 1 oder 2, wobei die Rampe (800) eine gerade Linie mit einer im Wesentlichen konstanten Steigung ist.

4. Verfahren nach Anspruch 3, wobei die Steigung der Rampe (800) in absoluten Werten im Bereich von 0,1 V/$\mu$s bis 10 V/$\mu$s, bevorzugt von 0,5 V/$\mu$s bis 1,5 V/$\mu$s liegt.

5. Verfahren nach einem der Ansprüche 1 bis 4, wobei der Drain (106D) des Transistors (100; 1000) während des Anlegens der Rampe (800) einer Drainspannung ($V_D$) im Bereich von 1 mV bis 500 mV ausgesetzt wird, bevorzugt von 50 mV bis 150 mV, in Bezug auf die Source (106S) des Transistors.

6. Verfahren nach einem der Ansprüche 1 bis 5, wobei die Source (106S) und ein Substrat (102; 1002) des Transistors während des Anlegens der Rampe (800) auf ein Bezugspotential, vorzugsweise die Masse, gebracht werden.

7. Verfahren nach einem der Ansprüche 1 bis 6, wobei die Änderungen der Gate-Kapazität (C) des Transistors (100; 1000) abgeleitet werden aus Änderungen des Verschiebungsstroms ($I_{dis}$) im Transistor während des Anlegens der Rampe (800).

8. Verfahren nach einem der Ansprüche 1 bis 7, wobei ein effektiver Mobilitätswert ($\mu_{eff}$) der Ladungsträger im Transistor (100; 1000) berechnet wird basierend auf:

    der Gate-Länge (L) des Transistors;
    der Gate-Breite (W) des Transistors
    dem Drainstrom ($I_D$) des Transistors;
    einer Drain-Spannung ($V_D$) des Transistors; und
    dem Integral der Gate-Kapazität (C) des Transistors in Bezug auf die Gate-Spannung ($V_G$) während des Anlegens der Rampe (800).

9. Verfahren nach einem der Ansprüche 1 bis 8, wobei ein Gate-Leckstrom ($I_G$) des Transistors (100; 1000) abgeleitet wird aus einer Messung des Source-Stroms (Is) und aus einer Messung des Drain-Stroms ($I_D$) während des Anlegens der Rampe (800).

10. Verfahren nach einem der Ansprüche 1 bis 9, wobei ein Offset ($\Delta V_{TH}$) der Schwellenspannung ($V_{TH}$) des Transistors (100; 1000) geschätzt wird während erster aufeinanderfolgender Phasen des Anlegens der Rampe (800) der Gatespannung ($V_G$), getrennt durch zweite Phasen des Anlegens einer konstanten Spannung ($V_{stress}$) ungleich Null an das Gate (106G; 1006G) des Transistors.

11. Elektronische Vorrichtung, die eingerichtet ist zum Umsetzen des Verfahrens nach einem der Ansprüche 1 bis 10, wobei die Vorrichtung Folgendes aufweist:

    das erste gepulste Strom-vs.-Spannungs-Messsystem (702), das mit dem Gate (106G; 1006G) des Transistors (100; 1000) gekoppelt, bevorzugt verbunden werden kann;
    ein Messwerterfassungssystem (704), das mit dem ersten gepulsten Strom-vs.-Spannungs-Kennlinienmesssystem (702) gekoppelt ist; und
    ein zweites gepulstes Strom-vs.-Spannungs-Messsystem (902), das mit dem Drain (106D) des Transistors gekoppelt, bevorzugt verbunden, werden kann wobei das erste System Folgendes anlegt:

        - Spannungsimpulse mit zunehmender Amplitude, wenn die Rampe (800) eine positive Steigung aufweist, und
        - Spannungsimpulse mit einer abnehmenden Amplitude, wenn die Rampe eine negative Steigung hat.

**Claims**

1. Method of characterizing a field-effect transistor (100; 1000), comprising:

    a step of application, to the gate (106G; 1006G) of the transistor, by a first pulsed current-vs.-voltage characteristic measurement system (702) configured to submit the gate to voltage pulses and to measure a resulting electric current ($I_{dis}$), of a single ramp (800) of the gate voltage ($V_G$);
    a step of measurement of a drain current ($I_D$) and of a gate capacitance (C) of the transistor (100; 1000) during the application of the ramp (800) of the gate voltage ($V_G$); and
    a step of interpretation both of variations of the gate capacitance (C) and of variations of the drain current ($I_D$) of the transistor.

2. Method according to claim 1, wherein the ramp (800) is applied for a time period in the range from 1 $\mu$s to 20 $\mu$s, preferably from 1 $\mu$s to 5 $\mu$s.

3. Method according to claim 1 or 2, wherein the ramp (800) is a straight line having a substantially constant slope.

4. Method according to claim 3, wherein the slope of the ramp (800) is in the range, in absolute value, from 0.1 V/$\mu$s to 10 V/$\mu$s, preferably from 0.5 V/$\mu$s to 1.5 V/$\mu$s.

5. Method according to any one of claims 1 to 4, wherein the drain (106D) of the transistor (100; 1000) is submitted, during the application of the ramp (800), to a drain voltage ($V_D$) in the range from 1 mV to 500 mV, preferably from 50 mV to 150 mV, with respect to the source (106S) of the transistor.

6. Method according to any one of claims 1 to 5, wherein the source (106S) and a substrate (102; 1002) of the transistor are, during the application of the ramp (800), taken to a reference potential, preferably the ground.

7. Method according to any one of claims 1 to 6, wherein the variations of the gate capacitance (C) of the transistor (100; 1000) are deduced from variations of the displacement current ($I_{dis}$) in the transistor during the application of the ramp (800).

8. Method according to any one of claims 1 to 7, wherein an effective mobility value ($\mu_{eff}$) of the carriers in the transistor (100; 1000) is calculated based on:

    the gate length (L) of the transistor;
    the gate width (W) of the transistor;
    the drain current ($I_D$) of the transistor;
    a drain voltage ($V_D$) of the transistor; and

the integral of the gate capacitance (C) of the transistor with respect to the gate voltage ($V_G$) during the application of the ramp (800).

9. Method according to any one of claims 1 to 8, wherein a gate leakage current ($I_G$) of the transistor (100; 1000) is deduced from a measurement of the source current ($I_S$) and from a measurement of the drain current ($I_D$) during the application of the ramp (800).

10. Method according to any one of claims 1 to 9, wherein an offset ($\Delta V_{TH}$) of the threshold voltage ($V_{TH}$) of the transistor (100; 1000) is estimated during first successive phases of application of the ramp (800) of the gate voltage ($V_G$), separated by second phases of application of a non-zero constant voltage ($V_{stress}$) to the gate (106G; 1006G) of the transistor.

11. Electronic device adapted to implementing the method according to any one of claims 1 to 10, the device comprising:

    the first pulsed current-vs.-voltage characteristic measurement system (702) which may be coupled, preferably connected, to the gate (106G; 1006G) of the transistor (100; 1000);
    a measurement acquisition system (704) coupled to the first pulsed current-vs.-voltage characteristic measurement system (702); and
    a second pulsed current-vs.-voltage characteristic measurement system (902) which may be coupled, preferably connected, to the drain (106D) of the transistor

    wherein the first system applies:

    - voltage pulses having an increasing amplitude, in a case where the ramp (800) has a positive slope; and
    - voltage pulses having a decreasing amplitude, in a case where the ramp has a negative slope.

Fig 1

Fig 2

Fig 3

Fig 4

Fig 5

Fig 6

702    PIV1      700      PC

704

106G

100

$V_S = 0V$           $V_D = 0V$

106S         106D

**Fig 7**

$V_G$

800

t0          t1    t

**Fig 8**

900

702    PIV1

PC

704

106G      100    902

PIV2

$V_S = 0V$

106S         106D

**Fig 9**

Fig 10

Fig 11

Fig 12

# EP 3 889 623 B1

## RÉFÉRENCES CITÉES DANS LA DESCRIPTION

**Documents brevets cités dans la description**

- GB 2351156 A